# EUROPÄISCHE PATENTANMELDUNG

(11) **EP 3 961 819 A1**
(43) Veröffentlichungstag der Anmeldung: **02.03.2022**
(21) Anmeldenummer: 21191495.7
(22) Anmeldetag: 16.08.2021
(51) Int. Cl.: H01R 12/51, H01R 12/70, H01R 13/58, H05K 3/30

(54) **KOPPELVORRICHTUNG, BAUGRUPPE UND VERFAHREN**

(30) Priorität: 24.08.2020 DE 102020122020
(71) Anmelder: MD Elektronik GmbH, 84478 Waldkraiburg (DE)
(72) Erfinder: Halbig, Thomas, 92345 Dietfurt (DE); Kefer, Hermann, 84503 Altötting (DE)

(57) **Zusammenfassung**

Die vorliegende Erfindung umfasst eine Koppelvorrichtung (100, 200, 300, 400, 500) zur Kopplung einer Anzahl von Leitungseinheiten (552, 553) mit einem Bauteilträger (551), wobei die Koppelvorrichtung (100, 200, 300, 400, 500) aufweist eine zumindest in einer Ebene flächig ausgebildete Grundplatte (101, 201, 301, 401, 501), eine Verbindungseinrichtung (102, 202, 302, 402), welche auf einer ersten Seite (113, 213, 313, 413) der Grundplatte (101, 201, 301, 401, 501) angeordnet ist und ausgebildet ist, die Grundplatte (101, 201, 301, 401, 501) mechanisch mit dem Bauteilträger (551) zu koppeln, und eine durch die Grundplatte (101, 201, 301, 401, 501) führenden Öffnung (107, 108, 109, 110, 111, 112, 207, 208, 209, 210, 211, 212, 307, 308, 309, 310, 311, 312, 549) für jedes Leitungsende (558, 559, 560) einer Anzahl von Leitungsenden (558, 559, 560) der Leitungseinheiten (552, 553), wobei die Öffnungen (107, 108, 109, 110, 111, 112, 207, 208, 209, 210, 211, 212, 307, 308, 309, 310, 311, 312, 549) an einer der jeweiligen Leitungseinheit (552, 553) entsprechenden Position auf der Grundplatte (101, 201, 301, 401, 501) angeordnet sind. Ferner umfasst die vorliegende Erfindung eine entsprechende Baugruppe (550) und ein entsprechendes Verfahren.

## Beschreibung

### Technisches Gebiet

Die Erfindung betrifft eine Koppelvorrichtung zur Kopplung einer Anzahl von Leitungseinheiten mit einem Bauteilträger, insbesondere an eine Trägerplatine. Ferner umfasst die vorliegende Erfindung eine entsprechende Baugruppe und ein entsprechendes Verfahren zum Herstellen der Baugruppe.

### Stand der Technik

Die vorliegende Erfindung wird hauptsächlich in Bezug auf mehradrige elektrische Leitungen, insbesondere Litzenleitungen, beschrieben. Es versteht sich, dass die vorliegende Erfindung dennoch mit jeder Art von Leitungen eingesetzt werden kann.

In modernen technischen Systemen, wie z.B. Fahrzeugen, wird heute üblicherweise eine Vielzahl elektrischer Einheiten verbaut. Aus Gründen der Effizienz können solche elektrischen Einheiten vormontiert werden und als Module in dem jeweiligen technischen System verbaut werden.

Dabei werden die einzelnen Module vor dem Verbau in das technische System montiert. Dabei müssen üblicherweise verschiedene mechanische und elektrische Elemente verbaut bzw. miteinander verbunden werden. Beispielsweise kann ein Steuergerät für ein Fahrzeug eine Trägerplatine aufweisen, auf welcher verschiedene Elemente, wie z.B. Controller mit entsprechender Peripherie, z.B. einer Stromversorgung und dergleichen, Anschlussterminals, Stecker, Kabel und dergleichen verbaut sein können. Eine solche Trägerplatine kann in einem Gehäuse angeordnet sein, welches die Trägerplatine kapselt und entsprechende Befestigungs- und Anschlussmöglichkeiten bietet.

Bei der Produktion solcher Module müssen die einzelnen Elemente auf der Trägerplatine montiert, also z.B. aufgelötet werden. Insbesondere die Befestigung von Kabeln auf einer solchen Trägerplatine ist ein aufwändiger und fehleranfälliger Prozess, da z.B. Kabelenden abknicken können und damit nicht korrekt verlötet werden können.

### Beschreibung der Erfindung

Es ist daher eine Aufgabe der vorliegenden Erfindung, eine einfache Verbindung von Kabeln mit einem Bauteilträger zu ermöglichen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Die vorliegende Erfindung offenbart:
Eine Koppelvorrichtung zur Kopplung einer Anzahl, also einer oder mehreren, von Leitungseinheiten mit einem Bauteilträger, wobei die Koppelvorrichtung aufweist: eine zumindest in einer Ebene flächig ausgebildete Grundplatte, eine Verbindungseinrichtung, welche auf einer ersten Seite der Grundplatte angeordnet ist und ausgebildet ist, die Grundplatte mechanisch mit dem Bauteilträger zu koppeln, und eine durch die Grundplatte führenden Öffnung für jedes Leitungsende einer Anzahl, also einem oder mehreren, von Leitungsenden der Leitungseinheiten, wobei die Öffnungen an einer der jeweiligen Leitungseinheit entsprechenden Position auf der Grundplatte angeordnet sind.

Die vorliegende Erfindung offenbart ferner:
Eine Baugruppe aufweisend: eine Anzahl von Leitungseinheiten mit jeweils einer Anzahl von Leitungsenden, einen flächig ausgebildeten Bauteilträger mit einem Kontaktelement für jedes der Leitungsenden, und eine Koppelvorrichtung nach einem der vorherigen Ansprüche, wobei die Koppelvorrichtung zwischen den Leitungseinheiten und dem Bauteilträger angeordnet ist und mechanisch zumindest mit dem Bauteilträger gekoppelt ist, und wobei jedes der Leitungsenden durch eine Öffnung der Koppelvorrichtung zu dem jeweiligen Kontaktelement reicht und mit dem jeweiligen Kontaktelement elektrisch gekoppelt ist.

Ferner offenbart die vorliegende Erfindung:
Ein Verfahren zum Herstellen einer Baugruppe, aufweisend die folgenden Schritte: Koppeln eines Bauteilträgers mit einer erfindungsgemäßen Koppelvorrichtung, Einführen von Leitungsenden in entsprechende Öffnungen der Koppelvorrichtung, und elektrisch Koppeln der Leitungsenden mit entsprechenden Kontaktelementen des Bauteilträgers.

Die vorliegende Erfindung basiert auf der Erkenntnis, dass insbesondere die Verbindung von Leitungen mit einem Bauteilträger, also z.B. einer Platine, ein sehr aufwändiger Prozess ist. Es muss bei einem solchen Verbindungsprozess sichergestellt werden, dass die einzelnen Enden der Leitungen korrekt durch die Platine geführt werden, dabei nicht abknicken und anschließend verlötet werden können. Ferner sollte für eine langlebige Verbindung der Leitungen mit der Trägerplatine eine Zugentlastung vorgesehen werden.

Um Leitungseinheiten mit einem Bauteilträger möglichst einfach in einer erfindungsgemäßen Baugruppe verbinden zu können, sieht die vorliegende Erfindung eine Koppelvorrichtung vor. Die Koppelvorrichtung dient der Kopplung einer oder mehrere Leitungseinheiten mit einem Bauteilträger der Baugruppe.

Die Baugruppe kann z.B. als eine elektrische oder elektronische Baugruppe mit passiven und/oder aktiven Bauteilen ausgebildet sein. Es versteht sich, dass die Begriffe "elektrisch" oder "elektronisch" im Rahmen der vorliegenden Erfindung gleichbedeutend sind und sowohl passive als auch aktive, analoge und/oder digitale Bauelemente betreffen können. Eine solche Baugruppe kann z.B. in einem komplexen technischen System, wie z.B. einem Fahrzeug verbaut werden.

Der Bauteilträger der Baugruppe kann z.B. eine Trägerplatine aufweisen, auf welcher elektronische und/oder mechanische Bauteile angeordnet sein können.

Um die Leitungseinheiten mit dem Bauteilträger zu koppeln, weist die Koppelvorrichtung eine flächig ausgebildete Grundplatte auf. Unter den Begriffen "flächig ausgebildet", ist zu verstehen, dass die Grundplatte zumindest einen flächigen Abschnitt aufweist, der sich in oder parallel zu einer Ebene erstreckt. Es versteht sich, dass die Grundplatte weitere Elemente aufweisen kann, die sich nicht in dieser Ebene erstrecken und z.B. aus dem flächigen Abschnitt hervortreten.

Die einzelnen Leitungseinheiten weisen jeweils eine Anzahl von Leitungsenden auf. Um die Leitungsenden mit dem Bauteilträger koppeln zu können, müssen die Leitungsenden von der zweiten, der ersten Seite gegenüberliegenden Seite der Grundplatte zur ersten Seite der Grundplatte geführt werden, welche dem Bauteilträger zugewandt ist. Dazu weist die Grundplatte für jedes der Leitungsenden eine Öffnung auf. Durch diese Öffnungen können die jeweiligen Leitungsenden zu dem Bauteilträger geführt werden.

Es versteht sich, dass die Leitungsenden entsprechend vorbereitet sein können. Es können also z.B. die Leitungsenden mechanisch in einer vorgegebenen Position fixiert werden. Damit ist beim Einführen der Leitungsenden in die Öffnungen sichergestellt, dass sich die Leitungsenden an den korrekten Positionen befinden.

Die Öffnungen für die einzelnen Leitungsenden für eine jeweilige Leitungseinheit können auf der Grundplatte an einer der jeweiligen Leitungseinheit und dem jeweiligen Leitungsende entsprechenden Position angeordnet sein. Damit ist sichergestellt, dass die Leitungsenden beim Verbinden der Koppelvorrichtung mit der jeweiligen Leitungseinheit durch die Öffnungen geführt werden und mit dem Bauteilträger elektrisch verbunden werden können.

Auf der ersten Seite der Grundplatte, also der Seite, welche dem Bauteilträger zugewandt ist, weist die Koppelvorrichtung eine Verbindungseinrichtung auf. Die Verbindungseinrichtung fixiert die Koppelvorrichtung mechanisch an dem Bauteilträger.

Es versteht sich, dass die Verbindungseinrichtung jede geeignete Art von Verbindungselementen aufweisen kann. Beispielsweise kann die Verbindungseinrichtung eine Rastverbindung zwischen der Koppelvorrichtung und dem Bauteilträger herstellen. Dazu kann die Verbindungseinrichtung entsprechende Rastnasenelemente oder Rasthakenelemente aufweisen, während der Bauteilträger entsprechende Ausnehmungen oder Öffnungen aufweisen kann, in welche die Rastnasenelemente oder Rasthakenelemente eingreifen können. Es versteht sich, dass andere geeignete Arten der Verbindung ebenfalls möglich sind. Beispielsweise können Schraubverbindungen, Press- oder Quetschverbindungen, Klebeverbindungen oder eine Kombination mehrerer der genannten Möglichkeiten vorgesehen sein.

Zur Montage einer erfindungsgemäßen Baugruppe kann zuerst der Bauteilträger mittels der Verbindungseinrichtung mit der Koppelvorrichtung mechanisch verbunden werden. Dies führt dazu, dass die Öffnungen in der Grundplatte über den entsprechenden Kontaktelementen des Bauteilträgers liegen.

Anschließend kann eine Leitungseinheit in die Koppelvorrichtung eingeführt werden.

Schließlich können die Leitungsenden z.B. durch einen Lötprozess elektrisch mit den Kontaktelementen gekoppelt werden. Es versteht sich, dass die Kontaktelemente z.B. als Durchkontaktierungen auf einer Leiterplatte ausgeführt sein können.

Mit Hilfe der erfindungsgemäßen Koppelvorrichtung wird es folglich möglich, Leitungseinheiten sehr einfach und effizient mechanisch und elektrisch mit einem Bauteilträger zu verbinden. Durch die Öffnungen wird dabei sichergestellt, dass die Leitungsenden korrekt positioniert und zu den Kontaktelementen geführt werden. Folglich kann insbesondere eine automatisierte Herstellung der Baugruppe mit einer hohen Qualität durchgeführt werden. Beispielsweise können mit Hilfe der Koppelvorrichtung die einzelnen Leitungseinheiten sehr einfach ausgerichtet werden. Dazu kann die Koppelvorrichtung z.B. entsprechende Positionierelemente oder Positionierhilfen aufweisen, wie unten im Detail erläutert.

Weitere Ausführungsformen und Weiterbildungen ergeben sich aus den Unteransprüchen sowie aus der Beschreibung unter Bezugnahme auf die Figuren.

In einer Ausführungsform kann die Koppelvorrichtung eine Koppeleinrichtung für jede der Leitungseinheiten aufweisen, welche auf einer zweiten, der ersten Seite gegenüberliegenden Seite der Grundplatte angeordnet ist und ausgebildet ist, die jeweilige Leitungseinheit in einem entsprechenden Aufnahmeraum aufzunehmen und mechanisch zu fixieren,

Auf der zweiten Seite der Grundplatte kann für zumindest eine der Leitungseinheiten eine Koppeleinrichtung vorgesehen sein. Die zweite Seite der Grundplatte ist diejenige Seite des flächigen Abschnitts der Grundplatte, auf welcher die Leitungseinheiten angeordnet werden. Die erste Seite bezeichnet dagegen wie oben bereits erläutert diejenige Seite des flächigen Abschnitts der Grundplatte, welcher im montierten Zustand der Baugruppe dem Bauteilträger zugewandt ist.

Die Koppeleinrichtungen dienen der mechanischen Fixierung der jeweiligen Leitungseinheiten an einer vorgegebenen Position. Dazu können die Koppeleinrichtungen einen Aufnahmeraum für jede der Leitungseinheiten definieren, in welchem die jeweilige Leitungseinheit aufgenommen und fixiert wird. Die Koppeleinrichtungen können dazu z.B. um den Aufnahmeraum herum bzw. an dessen Rand oder Umfang angeordnet sein. Es versteht sich, dass der Aufnahmeraum nicht abgeschlossen bzw. vollständig umschlossen sein muss.

Beispielsweise können die Koppeleinrichtungen eine Rastverbindung mit den Leitungseinheiten herstellen. Dazu können die Koppeleinrichtungen entsprechende Rastnasenelemente oder Rasthakenelemente aufweisen. Die Leitungseinheiten können entsprechende Rastvorsprünge oder Rastausnehmungen aufweisen, in welche die Rastnasenelemente oder Rasthakenelemente eingreifen können.

In einer weiteren Ausführungsform können die Koppeleinrichtungen als separate Elemente ausgebildet sein, die als Stecker auf den jeweiligen Aufnahmeraum gesteckt werden und z.B. mit der Grundplatte verrasten.

Die Koppeleinrichtungen fixieren die Leitungseinheiten und die Verbindungseinrichtung fixiert den Bauteilträger an der Koppelvorrichtung. Es wird folglich eine mechanische Einheit gebildet, welche für die elektrischen Verbindungen zwischen den Kontaktelementen und den Leitungsenden zusätzlich eine Zugentlastung bereitstellt.

In einer weiteren Ausführungsform kann die mindestens ein mechanisches Positionierelement aufweisen, welches ausgebildet ist, ein Koppeln der Verbindungseinrichtung mit dem Bauteilträger lediglich dann freizugeben, wenn die Koppelvorrichtung auf dem Bauteilträger in einer vorgegebenen Position angeordnet ist.

Durch das mechanische Positionierelement wird sichergestellt, dass die Koppelvorrichtung und der Bauteilträger lediglich in einer vorgegebenen Position zueinander miteinander gekoppelt werden. Ein Falscheinbau der Koppelvorrichtung auf dem Bauteilträger wird folglich verhindert.

Das mechanische Positionierelement setzt für die Koppelvorrichtung folglich das sogenannte "Poka Yoke" Prinzip um, bei welchem technische Vorkehrungen bzw. Einrichtungen zur Fehleraufdeckung und -vermeidung vorgesehen werden. Das ,Poka Yoke'-Prinzip ist bei der Koppelvorrichtung in dem Sinne verwirklicht, dass die Koppelvorrichtung abschnittsweise ein eines oder mehrere Elemente aufweisendes Positionierelement umfasst, das in Bezug auf den Bauteilträger so ausgestaltet bzw. angeordnet ist, dass eine Festlegung der Koppelvorrichtung an dem Bauteilträger nur in einer definierten Soll-Position möglich ist. Durch das mechanische Positionierelement wird ein Falscheinbau der Koppelvorrichtung verhindert, da die Verbindungseinrichtung nicht mit dem Bauteilträger gekoppelt werden kann, solange sie falsch, also abweichend von der definierten Soll-Position in Bezug auf den Bauteilträger, positioniert ist. Ferner würde ein solcher Versuch sofort entdeckt, da die Koppelvorrichtung z.B. lediglich locker auf dem Bauteilträger aufliegen würde.

Das mechanische Positionierelement kann dazu eines oder mehrere Elemente aufweisen. Diese Elemente können z.B. mit dem Bauteilträger derart interagieren, dass lediglich in der vorgegebenen Position ein Koppeln des Bauteilträgers mit der Koppelvorrichtung möglich ist.

Beispielsweise kann das mechanische Positionierelement Stifte aufweisen, die sich auf der ersten Seite der Grundplatte in Richtung auf den Bauteilträger erstrecken. In dem Bauteilträger können entsprechende Öffnungen für die Aufnahme der Stifte vorgesehen sein. Die Länge der Stifte ist dabei derart gewählt, dass nur bei korrekter Positionierung, also wenn die Stifte in die Öffnungen fahren können, die Koppelvorrichtung auf den Bauteilträger gesetzt und mit der Verbindungseinrichtung fixiert werden kann. Wird die Koppelvorrichtung in einer falschen Position auf den Bauteilträger aufgesetzt, stoßen die Stifte auf die Oberfläche des Bauteilträgers und verhindern ein Koppeln der Koppelvorrichtung mit dem Bauteilträger.

In einer Ausführungsform kann das mechanische Positionierelement auch in der Verbindungseinrichtung integriert sein. Wie oben bereits erläutert, kann die Verbindungseinrichtung z.B. Rastnasenelemente oder Schraubverbindungen vorsehen. Wird das mechanische Positionierelement in die Verbindungseinrichtung integriert, können diese Rastnasenelemente bzw. Schraubverbindungen oder dergleichen entsprechend derart positioniert werden, dass ein Falscheinbau ausgeschlossen ist.

Es versteht sich, dass das mechanische Positionierelement z.B. drei oder mehr Elemente aufweisen kann, welche den Falscheinbau verhindern. Würden lediglich zwei solche Elemente vorgesehen, könnte die Koppelvorrichtung eventuell um 180° gedreht verbaut werden. Dies kann mit drei oder mehr solcher Elemente effektiv verhindert werden.

In noch einer Ausführungsform kann die Koppelvorrichtung eine Aufnahmeraumbegrenzung, z.B. einem Kragen auf der Grundplatte, für jeden der Aufnahmeräume aufweisen, wobei insbesondere jede der Aufnahmeraumbegrenzungen eine eindeutige vorgegebene Geometrie aufweist.

Die Aufnahmeraumbegrenzungen können den jeweiligen Aufnahmeraum zumindest teilweise umschließen. Beispielsweise können die Aufnahmeraumbegrenzungen sich als Erhebung oder Kragen auf der zweiten Seite aus der Grundplatte erheben und so eine Art Wand oder Umrandung des jeweiligen Aufnahmeraums bilden. Es versteht sich, dass die einzelnen Aufnahmeraumbegrenzungen einstückig ausgebildet sein können, also gemeinsam die Aufnahmeräume umschließen können.

Die Aufnahmeraumbegrenzungen bilden damit gleichzeitig eine Führung, welche die Leitungseinheiten beim Positionieren auf der Grundplatte in die korrekte Position führen.

Es versteht sich, dass die Koppeleinrichtungen gemeinsam mit den Aufnahmeraumbegrenzungen ausgebildet sein können. In solch einer Ausführungsform können z.B. Rastnasenelemente oder Rasthakenelemente in der Aufnahmeraumbegrenzung vorgesehen werden.

In einer Ausführungsform können die einzelnen Aufnahmeraumbegrenzungen eine eindeutige vorgegebene Geometrie aufweisen. Damit weist jeder der Aufnahmeräume eine individuelle Geometrie auf. Die Leitungseinheiten können eine dem jeweiligen Aufnahmeraum entsprechende Geometrie aufweisen. Damit können lediglich die entsprechenden Leitungseinheiten in die jeweiligen Aufnahmeräume eingeführt werden. Ferner können die Geometrien der Aufnahmeräume unsymmetrisch ausgebildet sein. Damit kann auch ein verdrehtes Einsetzen der Leitungseinheiten verhindert werden.

In dieser Ausführungsform wird folglich das "Poka Yoke" Prinzip auch für die Kopplung der Leitungseinheiten mit der Grundplatte umgesetzt.

In noch einer weiteren Ausführungsform können die Öffnungen in der Grundplatte von der zweiten Seite zur ersten Seite einen sich verjüngenden Querschnitt aufweisen.

Die Öffnungen dienen wie oben bereits erläutert dazu, die Leitungsenden der einzelnen Leiter der Leitungseinheit zu führen und diese damit an den Kontaktelementen des Bauteilträgers zu positionieren.

Werden die Öffnungen mit einem sich verjüngenden Querschnitt vorgesehen, weisen diese auf der zweiten Seite der Grundplatte einen größeren Querschnitt auf, als auf der ersten Seite der Grundplatte. Beispielsweise können die Öffnungen trichterförmig ausgebildet sein.

Die einzelnen Öffnungen dienen folglich als Führungen für die einzelnen Leitungsenden, da die Leitungsenden über einen größeren Querschnitt aufgenommen werden und dann entlang der schrägen Innenfläche in die korrekte Position gleiten, falls sie nicht exakt mittig über den Öffnungen positioniert sind. Die Positioniergenauigkeit wird dabei durch den Querschnitt der Öffnung auf der ersten Seite des Bauteilträgers definiert.

Die Kontaktelemente des Bauteilträgers können z.B. als Durchkontaktierungen bzw. Bohrungen ausgebildet sein, durch welche die Leitungsenden zum Verlöten hindurchgeführt werden. Mit Hilfe der sich verjüngenden Öffnungen können die Leitungsenden folglich exakt über den Bohrungen angeordnet werden.

Folglich wird beim Zusammenfügen der Leitungseinheiten mit der Koppelvorrichtung und dem Bauteilträger sichergestellt, dass die Leitungsenden exakt positioniert sind und z.B. nicht abknicken.

In einer weiteren Ausführungsform können die Öffnungen an ihrem an der ersten Seite der Grundplatte liegenden Ende jeweils einen Anschlag aufweisen.

Der Anschlag kann z.B. in Form eines Vorsprungs oder einer Kante ausgeführt sein. Beispielsweise kann sich der Querschnitt der Öffnung kurz vor der ersten Seite der Grundplatte orthogonal zur Haupterstreckungsrichtung der Öffnung verjüngen. Ein solcher Anschlag kann z.B. als Anlagefläche für eine Endkante einer Ummantelung eines abgemantelten Leitungsendes dienen.

Die Leitungsenden können z.B. jeweils einen abisolierten End-Teil aufweisen, an welchem die Ummantelung entfernt wurde. An diesen abisolierten End-Teil kann sich ein isolierter Teil anschließen, an welchem die Ummantelung nicht entfernt wurde. Wird eine Leitungseinheit auf der Koppelvorrichtung positioniert, ragt folglich der abisolierte End-Teil durch den Bauteilträger und ein Ende des isolierten Teils, nämlich die bei dem Abisolieren entstandene Endkante der Ummantelung, liegt an der Anlagefläche an.

In einer weiteren Ausführungsform kann die Koppelvorrichtung eine Anzahl, also eines oder mehrere, von Distanzelementen aufweisen, welche auf der ersten Seite der Grundplatte angeordnet sind und eine vorgegebene Stärke aufweisen.

Die Distanzelemente dienen dazu, einen vorgegebenen Abstand zwischen der Grundplatte und dem Bauteilträger einzustellen und sicherzustellen, dass dieser Abstand nicht unterschritten wird. Dazu können die Distanzelemente eine Stärke oder Dicke aufweisen, welche dem vorgegebenen Abstand entspricht.

Entsprechende Distanzelemente können z.B. als Erhebungen auf der ersten Seite der Grundplatte ausgebildet sein. Zusätzlich oder alternativ können Distanzelemente auch in die Verbindungseinrichtung integriert sein. Beispielsweise können Rastelemente der Verbindungseinrichtung entsprechende Anschläge aufweisen.

Bei einem Lötvorgang, bei welchem die Leitungsenden mit dem Bauteilträger auf dessen Unterseite verlötet werden, entsteht auf Grund der Kapillarwirkung auch auf der Oberseite, also der der Koppelvorrichtung zugewandten Seite, ein Materialaufbau, auch Lötbuckel genannt. Durch den vorgegebenen Abstand wird sichergestellt, dass es zu keiner Beeinträchtigung der Lötverbindung kommt und dass kein Kontakt zwischen Lot und Koppelvorrichtung besteht.

In einer Ausführungsform kann die Koppelvorrichtung eine Anzahl, also einer oder mehreren, von Abdeckeinrichtungen aufweisen, welche sich ausgehend von der Grundplatte erstrecken.

Die Abdeckeinrichtungen dienen dazu, Elemente zumindest teilweise abzudecken bzw. abzuschirmen, die auf dem Bauteilträger, dort auf der der Koppelvorrichtung zugewandten Seite, angeordnet sind. Dazu können die Abdeckeinrichtungen je nach Anwendung bzw. Form des Bauteilträgers und Position der entsprechenden Elemente, ausgebildet werden.

Die Abdeckeinrichtungen können z.B. eine Haupterstreckungsrichtung aufweisen, welche in der Ebene der Grundplatte liegt. Es versteht sich, dass die Abdeckeinrichtungen auch komplexe dreidimensionale Formen aufweisen können, um z.B. Elemente in entsprechenden Aussparungen aufzunehmen, welche sich von dem Bauteilträger erheben.

Mit den Abdeckeinrichtungen können folglich Elemente derart geschützt werden, dass z.B. auf ein separates Gehäuse für die Baugruppe verzichtet werden kann.

In noch einer Ausführungsform kann die Koppelvorrichtung eine Anzahl, also eines oder mehrere, von Befestigungselementen aufweisen, welche ausgebildet sind, die Koppelvorrichtung mit einer externen Aufnahme mechanisch zu koppeln.

Die Befestigungselemente können z.B. als Rastverbindungselemente, z.B. als Rasthakenelemente oder Rastnasenelemente ausgebildet sein. Die Befestigungselemente können alternativ als Ausnehmungen ausgebildet sein, welche entsprechende Rastverbindungselemente der externen Aufnahme aufnehmen können. Es versteht sich, dass andere Arten von Befestigungselementen, wie z.B. Schraubverbindungselemente, ebenfalls möglich sind. Ferner versteht sich, dass unterschiedliche Arten von Befestigungselementen kombiniert werden können.

Die Befestigungselemente dienen dazu, die Koppelvorrichtung mit den Leitungseinheiten und dem Bauteilträger, also die gesamte Baugruppe, in der finalen Anwendung zu befestigen. Die Befestigungselemente können daher an der Grundplatte derart angeordnet sein, dass sie von dem Bereich, welcher die Leitungseinheiten aufnimmt, nach außen zeigen.

Wenn Wangen oder Kragen vorgesehen sind, welche die Bereiche definieren, welche die Leitungseinheiten aufnehmen, können die Befestigungselemente z.B. auf der Außenseite dieser Wangen oder Kragen angeordnet werden.

Ein technisches System, welches die Baugruppe aufnimmt, kann derart gestaltet werden, dass die Baugruppe über die Befestigungselemente in der gewünschten Position gehalten wird. Dabei kann die Aufnahme in dem technischen System Gehäuse-artig ausgebildet sein, so dass die Aufnahme die Baugruppe zumindest teilweise umschließt bzw. abdeckt. Damit kann auf ein separates Gehäuse für die Baugruppe verzichtet werden.

In noch einer Ausführungsform kann die Koppelvorrichtung eine Anzahl, also eine oder mehrere, von durch die Grundplatte führenden Schirmungsöffnungen für mindestens eine der Leitungseinheiten aufweisen, welche ausgebildet sind, Kontakte einer Schirmung der mindestens einen Leitungseinheit aufzunehmen.

Je nach Art der verwendeten Leitungen und Datenübertragungssysteme kann es nötig sein, die Leitungen zu schirmen. In solchen Fällen können auch die Enden der Leitungseinheiten geschirmt sein, welche mit der Koppelvorrichtung verbunden werden. Die Schirmungen der Leitungseinheiten können z.B. als entsprechende Blechabdeckungen ausgeführt sein, welche auf die Enden der Leitungseinheiten aufgepresst werden. Solche Blechabdeckungen weisen üblicherweise Kontaktstifte auf, um die Schirmung elektrisch zu kontaktieren. Die Schirmungsöffnungen können daher so ausgeführt werden, dass die Kontaktstifte durch die Koppelvorrichtung hindurch zu dem Bauteilträger reichen. Die Kontaktstifte können dann mit dem Bauteilträger z.B. verlötet werden.

Die Koppelvorrichtung kann in einer Ausführungsform ein einstückiges Formteil, insbesondere ein einstückiges Kunststoffteil, speziell ein einstückiges Kunststoff-Spritzteil sein, welche als Multifunktionsteil, die Leiterplatte, also den Bauteilträger, an deren Rand vorfixiert und Öffnungen bzw. Bohrungen aufweist, durch die Kontakte, also die Leitungsenden, der mehradrigen Leitungseinheiten gesteckt werden können, wobei weiter an der Innenwand des Multifunktionsteils Rastmittel vorgesehen sein können, um Gehäuse der Leitungseinheiten zu fixieren.

Die Koppelvorrichtung kann in einer Ausführungsform als dreidimensionales Kunststoff-Formteil mit einer flachen Bodenfläche, die einen vorgegebenen Abstand zu der flachen Leiterplatte, also dem Bauteilträger, einhält, und mit davon abstehenden Seitenflächen zur Begrenzung des Kunststoffs bzw. zur Ausrichtung, auch Codierung genannt, ausgebildet sein. Die vier Seitenflächen umgrenzen einen Aufnahmeraum innerhalb dessen die in einem sog. Litzensammler aufgenommenen, umspritzten Enden der mehradrigen Leitung aufgenommen sein können. Von der Seitenfläche fort können im wesentlichen horizontale Abschnitte weisen, beispielsweise als Lichtblenden und/oder Abdeckung für z.B. Gehäuse von Bauteilen oder Steckern, z.B. USB-Steckern. Von der Seitenfläche zu dem Bauteilträger, insbesondere zu der Leiterplatte weisend, können Anformungen vorgesehen sein, die nach innen weisende Halter, also z.B. Rasthaken oder Rastnasen, für die Kante der Leiterplatte ausbilden.

### Kurze Figurenbeschreibung

Nachfolgend werden vorteilhafte Ausführungsbeispiele der Erfindung unter Bezugnahme auf die begleitenden Figuren erläutert. Es zeigen:
- Figur 1: eine Seitenansicht einer Ausführungsform einer Koppelvorrichtung gemäß der vorliegenden Erfindung;
- Figur 2: eine Draufsicht auf die erste Seite der Ausführungsform der Koppelvorrichtung der Figur 1;
- Figur 3: eine Seitenansicht einer Ausführungsform einer weiteren Koppelvorrichtung gemäß der vorliegenden Erfindung;
- Figur 4: eine Draufsicht auf die zweite Seite der Ausführungsform der Koppelvorrichtung der Figur 3;
- Figur 5: eine Seitenansicht einer weiteren Ausführungsform einer Koppelvorrichtung gemäß der vorliegenden Erfindung;
- Figur 6: eine Draufsicht auf die erste Seite der Ausführungsform der Koppelvorrichtung der Figur 5;
- Figur 7: eine Seitenansicht einer weiteren Ausführungsform einer Koppelvorrichtung gemäß der vorliegenden Erfindung;
- Figur 8: eine perspektivische Ansicht einer weiteren Ausführungsform einer Koppelvorrichtung gemäß der vorliegenden Erfindung;
- Figur 9: eine perspektivische Ansicht einer Ausführungsform einer Baugruppe gemäß der vorliegenden Erfindung; und
- Figur 10: ein Ablaufdiagramm einer Ausführungsform eines Verfahrens gemäß der vorliegenden Erfindung.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

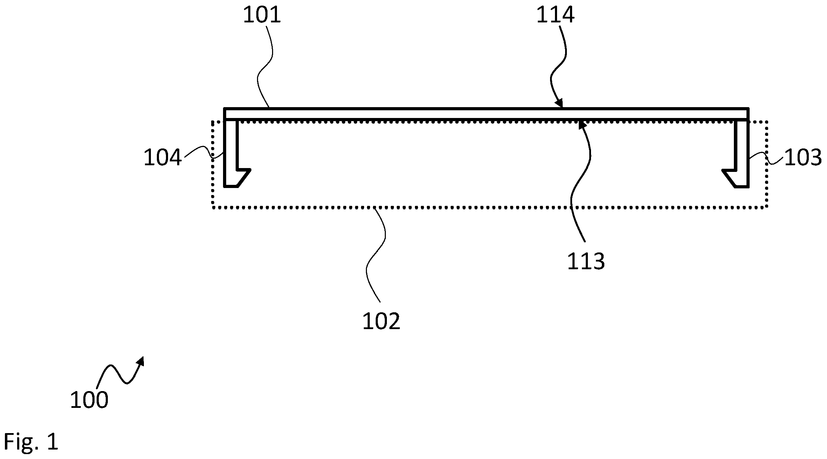

Figur 1 zeigt eine Seitenansicht einer Koppelvorrichtung 100. Die Koppelvorrichtung 100 kann als Hilfsmittel zur Kopplung einer Anzahl von Leitungseinheiten mit einem Bauteilträger, insbesondere einer Leiterplatte, vorgesehen und verwendet werden.

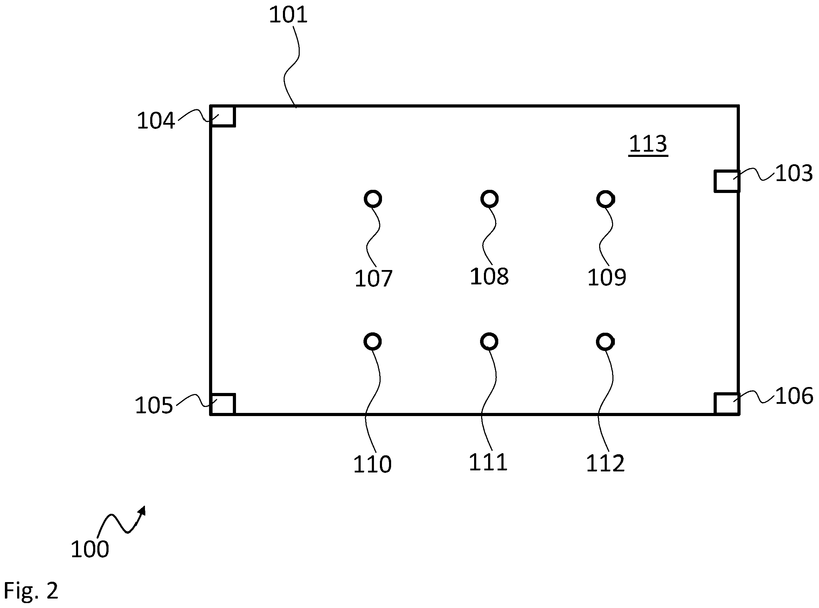

Die Koppelvorrichtung 100 weist eine zumindest in einer Ebene flächig ausgebildete Grundplatte 101 auf. An einer ersten Seite 113 der Grundplatte 101 ist eine Verbindungseinrichtung 102 angeordnet. Die Verbindungseinrichtung 102 ist geeignet, die Grundplatte 101 mechanisch mit dem Bauteilträger zu koppeln. Bei der Koppelvorrichtung 100 weist die Verbindungseinrichtung 102 dazu Rasthaken 103, 104, 105 (siehe Figur 2), 106 (siehe Figur 2) auf, welche z.B. entsprechend formschlüssig in einen entsprechenden Bauteilträger eingreifen können. Es versteht sich, dass dieses Prinzip auch umgekehrt werden kann, und die Verbindungseinrichtung 102 z.B. entsprechende Ausnehmungen aufweisen kann, in die auf dem Bauteilträger angeordnete Verbindungseinrichtungen eingreifen können. Ferner kann die Verbindungseinrichtung 102 z.B. auch Löcher zur Schraubenaufnahme oder andere Befestigungsmittel aufweisen.

Um über die Koppelvorrichtung 100 Leitungseinheiten mit dem Bauteilträger koppeln zu können, wird der Bauteilträger über die Verbindungseinrichtung mit der Koppelvorrichtung 100 gekoppelt. Ferner führt durch die Grundplatte 101 für jedes Leitungsende der Leitungseinheiten eine entsprechende Öffnung 107, 108, 109, 110, 111, 112, die jeweils als Durchgangsbohrung ausgebildet ist, die die Grundplatte 101 durchsetzt. In der Seitenansicht der Figur 1 sind diese Öffnungen 107, 108, 109, 110, 111, 112 nicht zu sehen, werden aber in der Draufsicht der Figur 2 gezeigt.

Die einzelnen Öffnungen 107, 108, 109, 110, 111, 112 können in Ausführungsformen einen sich von der zweiten Seite 114 zur ersten Seite 113 verjüngenden Querschnitt aufweisen. Die Öffnungen 107, 108, 109, 110, 111, 112 können trichterartig oder trichterförmig bzw. konisch ausgebildet sein. Wird ein Leitungsende in eine der Öffnungen 107, 108, 109, 110, 111, 112 eingeführt, wird das jeweilige Leitungsende über den größeren Durchmesser der Öffnung 107, 108, 109, 110, 111, 112 auf der zweiten Seite 114 aufgenommen. Für den Fall, dass das Leitungsende nicht exakt mittig in der Öffnung 107, 108, 109, 110, 111, 112 platziert ist, gleitet das Leitungsende folglich entlang der sich verjüngenden Seitenwand der Öffnung. Damit wirken die Öffnungen 107, 108, 109, 110, 111, 112 beim Einführen von Leitungsenden in die Öffnungen 107, 108, 109, 110, 111, 112 als Positionierhilfe.

Eine exakte und einfach zu automatisierende Montage der Leitungseinheiten in einer Baugruppe wird damit möglich.

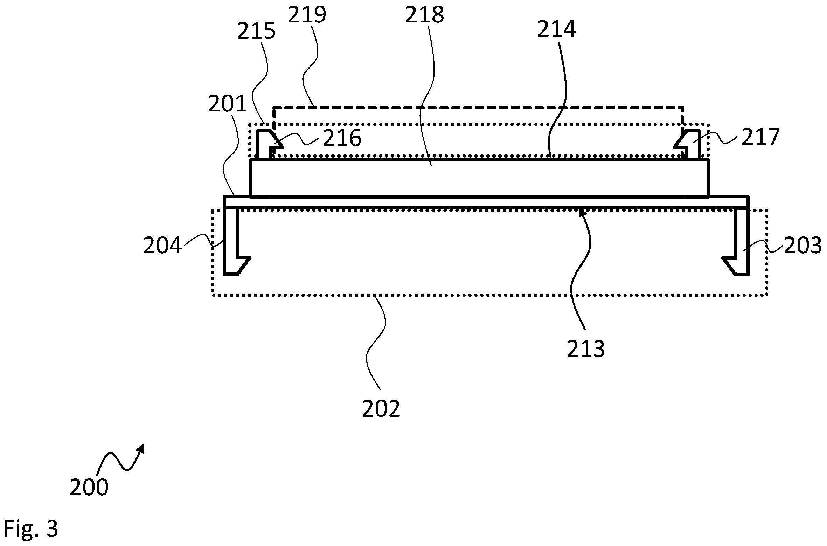

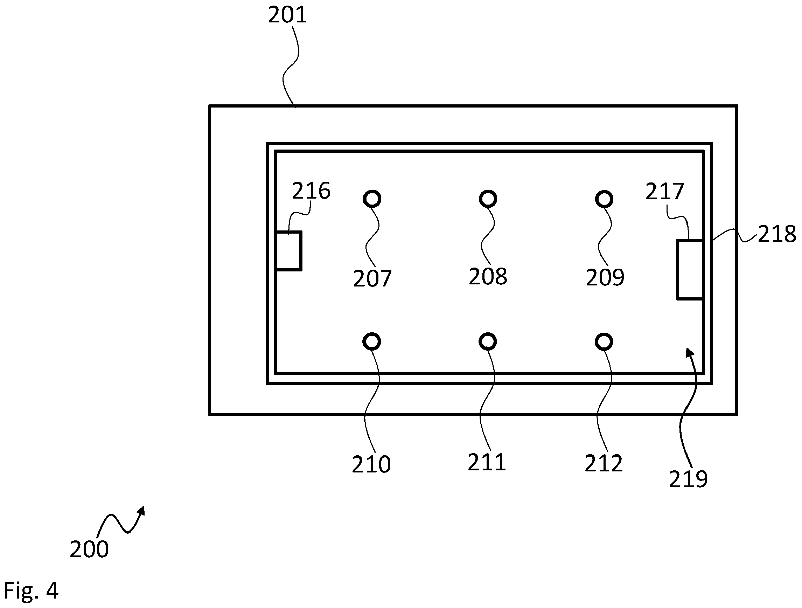

Wie weiter unten z.B. in Bezug auf Figuren 3 und 4 näher erläutert, kann die Koppelvorrichtung 100 auch weitere Elemente aufweisen, welche dazu dienen, die Leitungseinheiten aufzunehmen, zu fixieren und/oder zu positionieren.

Figur 2 zeigt eine Draufsicht auf die erste Seite 113 der Koppelvorrichtung 100.

In der Draufsicht auf die Koppelvorrichtung 100 ist zu erkennen, dass die Öffnungen 107, 108, 109, 110, 111, 112 in zwei parallelen Reihen zu je drei Öffnungen 107, 108, 109 und 110, 111, 112 angeordnet sind. Es versteht sich, dass diese Anordnung der Öffnungen 107, 108, 109, 110, 111, 112 lediglich beispielhaft gewählt wurde und dass jede andere geeignete Anordnung der Öffnungen 107, 108, 109, 110, 111, 112 ebenfalls möglich ist. Insbesondere können die Öffnungen 107, 108, 109, 110, 111, 112 entsprechend der Positionen entsprechender Leitungsenden an den Leitungseinheiten angeordnet werden. Ferner versteht sich, dass die einzelnen Öffnungen 107, 108, 109, 110, 111, 112 unterschiedliche Durchmesser und/oder Umrisse aufweisen können. Ferner versteht sich, dass Öffnungen zur Aufnahme von Leitungsenden von mehr als einer Leitungseinheit vorgesehen sein können.

Die Rasthaken 103, 104, 105, 106 sind auf der Grundplatte 101 asymmetrisch angeordnet. Dabei sind die Rasthaken 103, 106 an der rechten Kante der Grundplatte 101 angeordnet und die Rasthaken 105, 106 an der linken Kante der Grundplatte 101. Der Abstand zwischen den Rasthaken 103, 104 ist geringer, als der Abstand zwischen den Rasthaken 105, 106. Auf einem Bauteilträger können entsprechende Gegenstücke für die Rasthaken 103, 104, 105, 106 in entsprechenden Abständen angeordnet werden. Die Positionen der Rasthaken 103, 104, 105, 106 ermöglichen folglich keinen Falschverbau der Koppelvorrichtung 100 auf einem Bauteilträger. Die Rasthaken 103, 104, 105, 106 erfüllen damit auch die Funktion eines mechanischen Positionierelements, welches das sog. "Poka Yoke" Prinzip umsetzt. Es versteht sich, dass zusätzlich oder alternativ ein separates mechanisches Positionierelement vorgesehen sein kann.

Figur 3 zeigt eine Seitenansicht eines weiteren Ausführungsbeispiels einer erfindungsgemäßen Koppelvorrichtung 200. Die Koppelvorrichtung 200 basiert auf der Koppelvorrichtung 100 in dem Sinne, dass das in Fig. 1, 2 dargestellte erste Ausführungsbeispiel einer erfindungsgemäßen Koppelvorrichtung 100 ergänzend weitergebildet wurde. Es gilt damit das oben zur Koppelvorrichtung 100 beschriebene analog. Die Koppelvorrichtung 200 weist ebenfalls eine zumindest in einer Ebene flächig ausgebildete Grundplatte 201 auf. An einer ersten Seite 213 der Grundplatte 201 ist eine Verbindungseinrichtung 202 angeordnet, welche geeignet ist, die Grundplatte 201 mechanisch mit einem Bauteilträger zu koppeln. Die Verbindungseinrichtung 202 weist dazu vier Rasthaken 203, 204, 205 (siehe Figur 4), 206 (siehe Figur 4) auf, welche z.B. entsprechend formschlüssig in den Bauteilträger eingreifen können.

Die Koppelvorrichtung 200 weist ferner auf der zweiten Seite 214 eine Koppeleinrichtung 215 zur Aufnahme einer Leitungseinheit in einem entsprechenden Aufnahmeraum 219 auf. Bei der Koppelvorrichtung 200 weist die Koppeleinrichtung 215 dazu zwei Rasthaken 216, 217 auf, welche mit einer Leitungseinheit verrasten können. Ferner ist eine Aufnahmeraumbegrenzung 218 vorgesehen, welche den Aufnahmeraum 219 umfasst, hierzu den Aufnahmeraum 219 mindestens abschnittsweise umläuft und randseitig begrenzt. Dazu steht die Aufnahmeraumbegrenzung 218 über die zweite Seite 214 der Grundplatte 201 vor, und zwar mindestens abschnittsweise entlang des Randes der Grundplatte 201 abschnittweise im Wesentlichen senkrecht.

Die Koppelvorrichtung 200 ist dazu ausgebildet, mindestens eine Leitungseinheit, insbesondere zwei oder mehr Leitungseinheiten relativ zu einander lagerichtig mechanisch an die Grundplatte 201 zu koppeln. Dazu kann die mindestens eine Leitungseinheit z.B. entsprechende Gegenstücke für die Rasthaken 216, 217 aufweisen in welche diese eingreifen können. Es versteht sich, dass auch hier das Prinzip umgekehrt werden kann und die Rastelement in der Leitungseinheit vorgesehen sein können. Die Koppeleinrichtung 215 kann in solch einer Ausführung z.B. entsprechende Ausnehmungen aufweisen. Obwohl nur eine Koppeleinrichtung 215 dargestellt ist, versteht sich, dass weitere Koppeleinrichtungen möglich sind, um weitere Leitungseinheiten aufzunehmen.

Figur 4 zeigt eine Draufsicht auf die zweite Seite 214 der Koppelvorrichtung 200 der Figur 3. In der Figur 3 ist zu sehen, dass auch die Koppeleinrichtung 215 ausgebildet sein kann, einen Falscheinbau der Leitungseinheit mechanisch zu unterbinden, also das "Poka Yoke" Prinzip umzusetzen. Dazu sind die zwei Rasthaken 216, 217 mit unterschiedlich Abmessungen ausgebildet, so dass der eine Rasthaken 217 z.B. nicht in eine Aufnahme für den anderen Rasthaken 216 passt. Ferner sind die Rasthaken 216, 217 asymmetrisch zu einer Mittelachse des Aufnahmeraums 219 angeordnet. Eine bestimmte, mittels der Rasthaken 216, 217 zu fixierende Leitungseinheit kann daher nur auf eine definierter Weise in dem Aufnahmeraum 219 fixiert werden. Die genannte Leitungseinheit kann folglich nicht falsch in den Aufnahmeraum 219 eingesetzt werden. Ein Falscheinbau einer Leitungseinheit wird folglich effektiv verhindert, so dass insbesondere auch ein automatisierter Einbau von Leitungseinheiten in hoher Stückzahl in kurzer Prozesszeit ermöglicht wird.

Es versteht sich, dass bei Vorhandensein mehrere Leitungseinheiten und entsprechender Koppeleinrichtungen diese mechanisch jeweils unterschiedlich ausgebildet sein können, so dass eine Leitungseinheit nur in den durch die jeweilige Koppeleinrichtung definierten Aufnahmeraum eingesetzt werden kann.

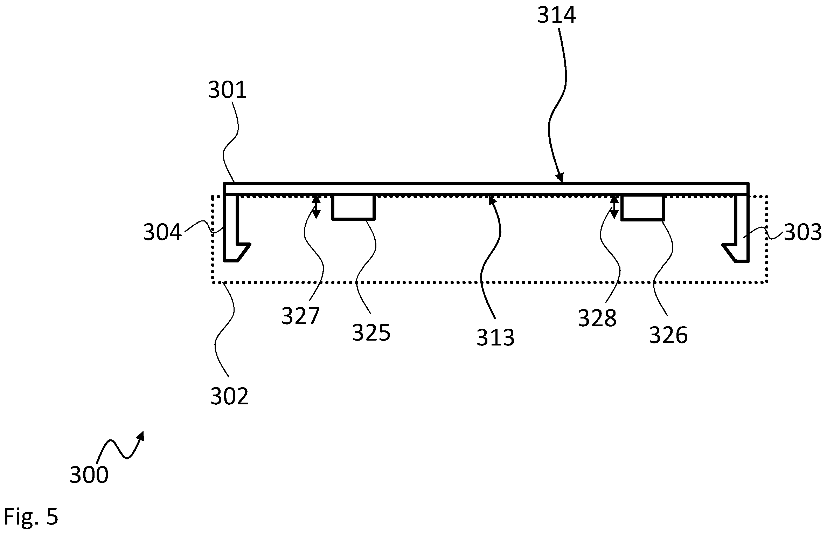

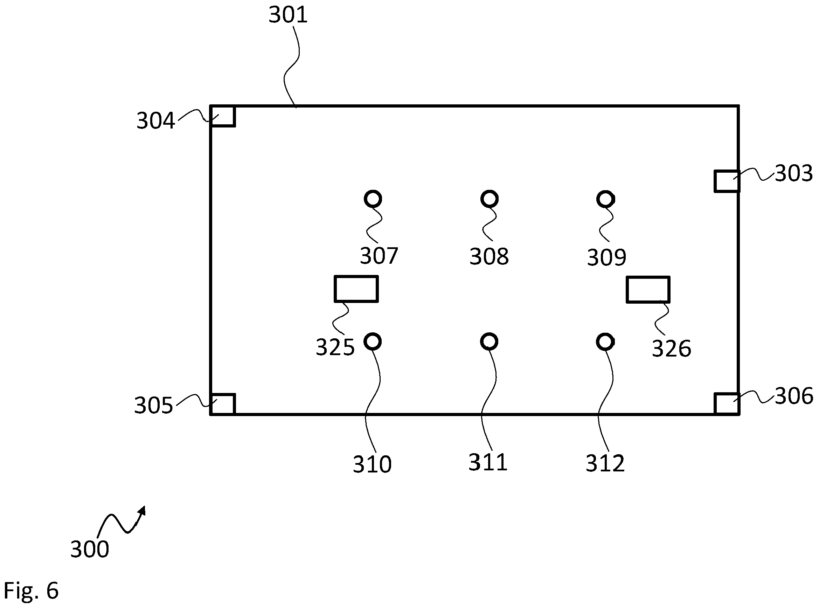

Figur 5 zeigt eine Seitenansicht eines dritten Ausführungsbeispiels einer erfindungsgemäßen Koppelvorrichtung 300. Die Koppelvorrichtung 300 basiert ebenfalls auf der Koppelvorrichtung 100 in dem Sinne, dass sie die in Fig. 1, 2 dargestellte erste Koppelvorrichtung 100 konstruktiv fortbildet. Es gilt damit das oben zur Koppelvorrichtung 100 beschriebene analog. Die Koppelvorrichtung 300 weist ebenfalls eine zumindest in einer Ebene flächig ausgebildete Grundplatte 301 auf. An einer ersten Seite 313 der Grundplatte 301 ist eine Verbindungseinrichtung 302 angeordnet, welche geeignet ist die Grundplatte 301 mechanisch mit einem Bauteilträger zu koppeln. Die Verbindungseinrichtung 302 weist dazu vier Rasthaken 303, 304, 305 (siehe Figur 6), 306 (siehe Figur 6) auf, welche z.B. entsprechend formschlüssig in den Bauteilträger eingreifen können.

Die Koppelvorrichtung 300 weist ferner zwei Distanzelemente 325, 326 mit einer vorgegebenen Stärke 327, 328 auf, also eine vorgegebene Erstreckung in einer Richtung senkrecht zu der Ebene der ersten Seite 313 der Grundplatte 301. Die Distanzelemente 325, 326 dienen als Auflager für den Bauteilträger bzw. als Abstandhalter zu dem Bauteilträger und verhindern, dass der Abstand zwischen Oberseite des Bauteilträgers und einer Unterseite der Grundplatte 301 die vorgegebene Stärke 327, 328 unterschreitet.

Figur 6 zeigt eine Draufsicht auf die erste Seite 313 der Koppelvorrichtung 300. Das Distanzelement 325 ist zwischen den Öffnungen 307 und 310 angeordnet und das Distanzelement 326 ist rechts der Verbindungslinie zwischen den Öffnungen 309, 312 angeordnet. Es versteht sich, dass die Position und die Anzahl der Distanzelemente 325, 326 hier lediglich beispielhaft gewählt wurden. In weiteren Ausführungsbeispielen können die Anzahl der Distanzelemente und / oder die Positionierung der Distanzelemente an der Grundplatte 301 von den in Fig. 5, 6 dargestellten Ausführungsbeispiel abweichen. In einer weiteren Abwandlung des in Fig. 5, 6 dargestellten dritten Ausführungsbeispiels können die Distanzelemente auch z.B. in die Verbindungseinrichtung 302 (Fig. 5) baulich integriert und beispielsweise als Anformungen an den Rasthaken 303, 304, 305, 306 ausgebildet sein.

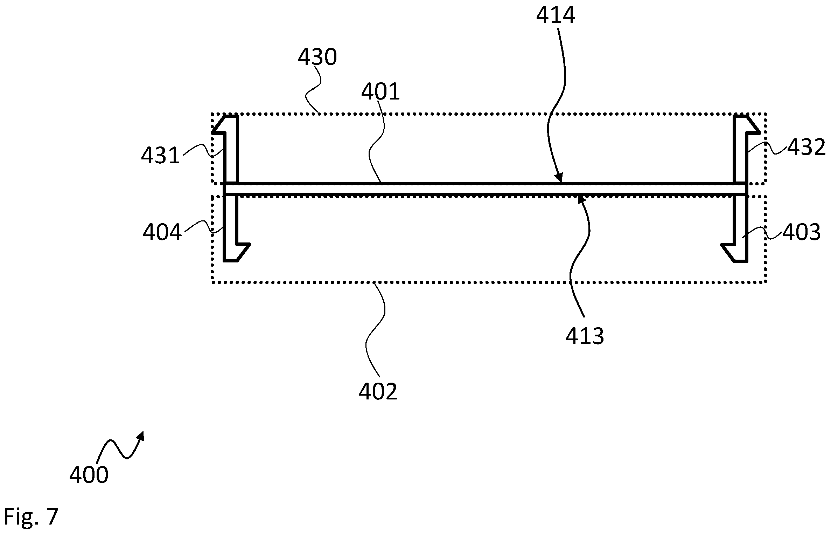

Figur 7 zeigt eine Seitenansicht eines vierten Ausführungsbeispiels einer erfindungsgemäßen Koppelvorrichtung 400. Die Koppelvorrichtung 400 basiert auf der Koppelvorrichtung 100 in dem Sinne, dass die vierte Koppelvorrichtung 400 eine konstruktive Weiterbildung der ersten Koppelvorrichtung 100 darstellt. Es gilt damit das oben zu der ersten Koppelvorrichtung 100 beschriebene sinngemäß entsprechend. Die Koppelvorrichtung 400 weist ebenfalls eine zumindest in einer Ebene flächig ausgebildete Grundplatte 401 auf. An einer ersten Seite 413 der Grundplatte 401 ist eine Verbindungseinrichtung 402 angeordnet, welche geeignet ist, die Grundplatte 401 mechanisch mit einem Bauteilträger zu koppeln. Die Verbindungseinrichtung 402 weist dazu vier Rasthaken 403, 404, 405, 406 auf, welche z.B. entsprechend formschlüssig in den Bauteilträger eingreifen können.

Die Koppelvorrichtung 400 weist ferner ein Befestigungselement 430 auf, welches dazu dient, die Koppelvorrichtung 400 extern zu fixieren, also z.B. in der jeweiligen Anwendung zu verbauen. Das Befestigungselement 430 weist in dem dargestellten Ausführungsbeispiel der Koppelvorrichtung 400 zwei Rasthaken 431, 432 auf.

Bei den Rasthaken 403, 404 der Verbindungseinrichtung 402 weisen die Nasen aufeinander zu, zeigen also nach innen. Im Gegensatz zu den Rasthaken 403, 404 der Verbindungseinrichtung 402 weisen die Nasen der Rasthaken 431, 432 voneinander weg, zeigen also jeweils nach außen. Damit können die Rasthaken 431, 432 sehr einfach in entsprechende Aufnahmen an einem entsprechenden Installationsort eingreifen. Eine weitere Befestigung einer mit der Koppelvorrichtung 400 erstellten Baugruppe ist daher nicht nötig.

Es versteht sich, dass anstelle der Rasthaken 431, 432 auch Ausnehmungen für Rasthaken oder andere Befestigungsmittel vorgesehen sein können.

Es versteht sich, dass in unterschiedlichen Ausführungen einer Koppelvorrichtung Merkmale der einzelnen Ausführungen der Figuren 1 bis 7 kombiniert werden können. Beispielsweise kann eine Koppelvorrichtung eine Koppeleinrichtung mit oder ohne eine Aufnahmeraumbegrenzung und/oder Distanzelemente und/oder mindestens ein Befestigungselement aufweisen.

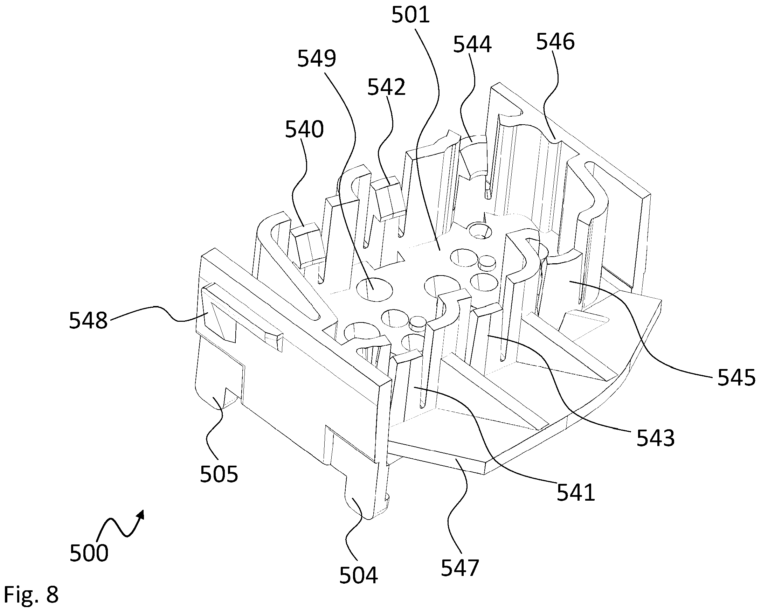

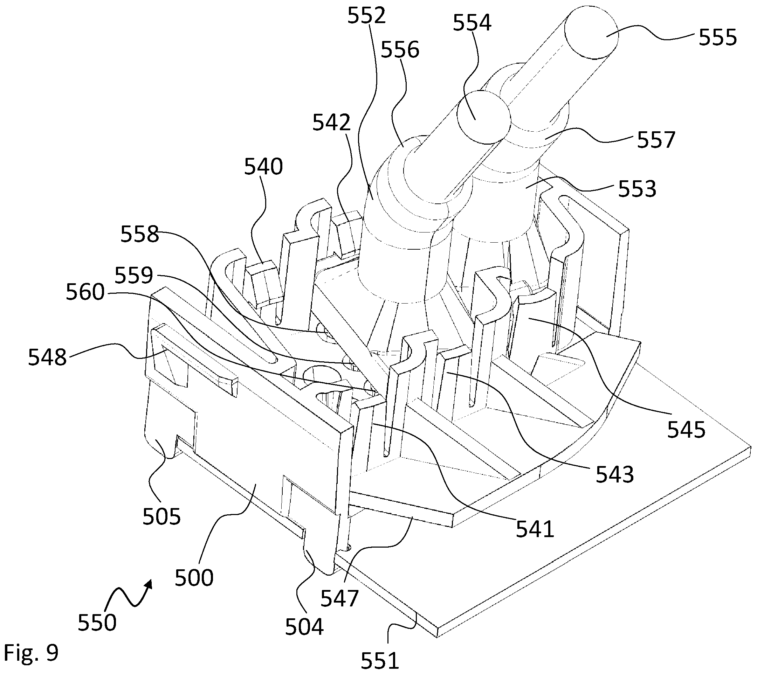

Figur 8 zeigt eine perspektivische Ansicht eines fünften Ausführungsbeispiels einer erfindungsgemäßen Koppelvorrichtung 500. Die Koppelvorrichtung 500 weist eine Grundplatte 501 auf. Auf der zweiten Seite, also der Oberseite der Grundplatte 501 ist eine umlaufende Aufnahmeraumbegrenzung 546 für drei Aufnahmeräume vorgesehen. Dabei werden die Aufnahmeräume an den gemeinsamen Flächen nicht durch die Aufnahmeraumbegrenzung 546 getrennt, so dass zwei benachbarte Aufnahmeräume an der gedachten gemeinsamen Fläche ineinander übergehen. An zwei sich gegenüberliegenden Kanten der Grundplatte 501 weist die Aufnahmeraumbegrenzung 546 zwei sich über der jeweiligen Kante senkrecht aus der Grundplatte 501 erhebende Wände auf. An diesen Wänden ist jeweils ein Befestigungselement 548 in Form einer Erhebung vorgesehen. Die Erhebung bildet mit der jeweiligen Wand eine Ausnehmung bzw. einen Raum aus, in welchen z.B. ein Rasthaken eingreifen kann, um die Koppelvorrichtung 500 bzw. eine entsprechende Baugruppe extern zu fixieren. Ferner erstreckt sich von einer dritten Kante der Grundplatte 501 aus eine flächige Abdeckeinrichtung 547. Die Abdeckeinrichtung 547 dient der Abdeckung eines Bauteilträgers bzw. der auf dem Bauteilträger angeordneten Bauelemente. Die flächige Abdeckeinrichtung 547 erstreckt sich unter einem insbesondere flachen Winkel zu der Grundplatte 501 von dieser weg, so dass der Abstand zwischen dem Bauteilträger und der flächigen Abdeckeinrichtung 547 sich ausgehend von der Kante der Grundplatte 501 vergrößert. Es versteht sich, dass die Form und Anordnung der flächigen Abdeckeinrichtung 547 an die Bauteile des jeweiligen Bauteilträgers angepasst werden kann. Auf der ersten Seite der Grundplatte 501, also in Figur 8 nach unten weisend, sind Rasthaken 504, 505 für eine Verbindungseinrichtung angeordnet, um einen Bauteilträger aufzunehmen und zu fixieren (siehe Figur 9). Es versteht sich, dass neben den zwei sichtbaren Rasthaken 504, 505 weitere Rasthaken, insbesondere zwei weitere Rasthaken, vorgesehen sein können, die in der Darstellung der Figur 8 nicht sichtbar sind.

Bei der Koppelvorrichtung 500 sind die Rasthaken 540, 541, 542, 543, 544, 545 für drei Koppeleinrichtungen in die Aufnahmeraumbegrenzung 546 integriert. Die Rasthaken 540, 541, 542, 543, 544, 545 weisen dazu in die entsprechenden Aufnahmeräume ragende Nasen auf, welche in entsprechend geformte Leitungseinheiten eingreifen können. In der Grundplatte 501, also am Boden der jeweiligen Aufnahmeräume, sind Öffnungen für Enden von Leitungen der jeweiligen Leitungseinheiten vorgesehen. Der Übersichtlichkeit halber ist lediglich eine der Öffnungen mit einem Bezugszeichen ,549' versehen. Die Öffnungen 549 sind als die Grundplatte 501 durchsetzende Durchbrechungen ausgebildet und weisen einen konischen bzw. einen sich verjüngenden Querschnitt auf, so dass sie jeweils als Positionierhilfe bei dem Einführen der Leitungsenden dienen, wie oben zu Fig. 1 erläutert wurde.

Figur 9 zeigt eine perspektivische Ansicht eines Ausführungsbeispiels einer erfindungsgemäßen Baugruppe 550 mit der Koppelvorrichtung 500 gemäß Figur 8. Die Baugruppe 550 umfasst dabei die Koppelvorrichtung 500 sowie einen Bauteilträger 551, der insbesondere als Leiterplatte ausgebildet ist. Bei der Baugruppe 550 ist die Koppelvorrichtung 500 mit dem Bauteilträger 551 gekoppelt, so dass der Bauteilträger 551 mit der Koppelvorrichtung 500 so weit fixiert verbunden ist, dass die Baugruppe 550 als vormontierte Baueinheit weiterbearbeitet werden kann. Der Bauteilträger 551 wurde von unten bzw. von der ersten Seite her in die Verbindungseinrichtung eingesetzt und wird von den Rasthaken 504, 505 und den weiteren nicht sichtbaren Rasthaken fixiert.

Von oben, also von der zweiten Seite her sind zwei Leitungseinheiten 552, 553 dargestellt. Die Leitungseinheiten 552, 553 sind in die Aufnahmeräume der Rasthaken 542, 543 und 544, 545 eingesetzt. Es versteht sich, dass in den Aufnahmeraum der durch die Rasthaken 540, 541 gekennzeichnet ist, ebenfalls eine Leitungseinheit eingesetzt werden kann, welche aber der Übersichtlichkeit halber hier nicht dargestellt ist. Die Leitungseinheiten 552, 553 weisen an Ihrem Ende jeweils eine Ummantelung 556, 557 auf, z.B. eine Spritzguss-Ummantelung, welche als Positioniereinheit und mechanisches Verbindungselement dient und die jeweilige Leitung 554, 555 nahe einem Endabschnitt umgibt und ummantelt. Die Ummantelungen 556, 557 sind derart ausgebildet, dass sie in den jeweiligen Aufnahmeraum eingeführt werden können und dort mit den Rasthaken 542, 543, 544, 545 verrasten.

Jede der Leitungseinheiten 552, 553 weist eine Anzahl von Leitungsenden 558, 559, 560 auf. In Figur 9 sind drei Leitungsenden 558, 559, 560 der Leitungseinheit 552 sichtbar. Die Leitungsenden 558, 559, 560 der Leitungseinheiten sitzen in den Öffnungen der Grundplatte 501 und sind elektrisch mit entsprechenden Kontaktelementen des Bauteilträgers 551 gekoppelt.

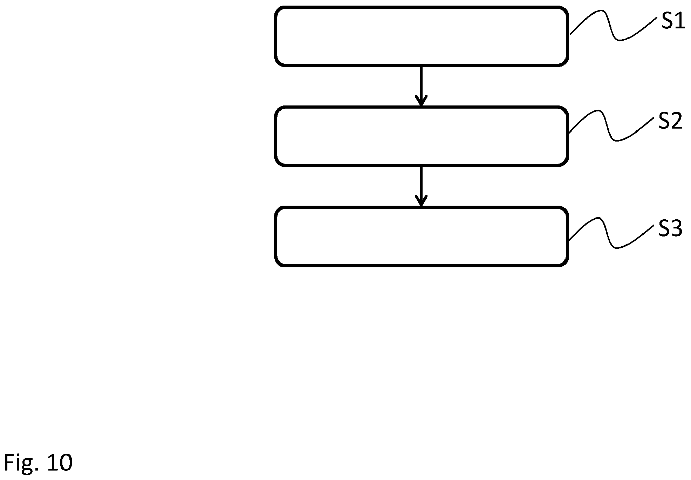

Figur 10 zeigt ein Ablaufdiagramm einer beispielhaften Durchführung des erfindungsgemäßen Verfahrens zum Herstellen einer Baugruppe 550.

In einem ersten Schritt S1 wird ein Bauteilträger 551 mit einer Koppelvorrichtung 100, 200, 300, 400, 500 gekoppelt. In einem zweiten Schritt S2 werden Leitungsenden 558, 559, 560 in entsprechende Öffnungen 107, 108, 109, 110, 111, 112, 207, 208, 209, 210, 211, 212, 307, 308, 309, 310, 311, 312, 549 der Koppelvorrichtung 100, 200, 300, 400, 500 eingeführt. Schließlich werden in einem dritten Schritt S3 die Leitungsenden 558, 559, 560 mechanisch fest sowie elektrisch leitend mit entsprechenden Kontaktelementen des Bauteilträgers 551 verbunden; dieses Verbinden kann beispielsweise durch einen Schritt eines Verlötens, insbesondere durch ein Wellenlöten oder Schwalllöten, durchgeführt werden.

In einer bevorzugten Durchführung des Verfahrens werden vor dem Einführen S2 die Leitungsenden 558, 559, 560 in einer Positioniereinheit 556, 557 mechanisch fixiert. Ferner können die Leitungsenden 558, 559, 560 z.B. in einem Zinnbad behandelt, also verzinnt werden, so dass die Leitungsenden 558, 559, 560 mit einer Zinnschicht bedeckt sind. Dies erleichtert das spätere Verlöten der Leitungsenden 558, 559, 560. Es versteht sich, dass je nach Methode der Kontaktierung die Leitungsenden 558, 559, 560 vor dem Einführen S2 auch abisoliert werden können.

Die Leitungsenden 558, 559, 560 können vor dem Einführen S2 jeweils auch mit einem mechanischen Verbindungselement versehen werden, welches um die Leitung der Leitungseinheit 552, 553 angeordnet ist. Ein solches mechanisches Verbindungselement kann z.B. ein Spritzgussteil sein und mechanisch, also z.B. über Rastmittel, in eine Koppeleinrichtung 215 der Koppelvorrichtung 100, 200, 300, 400, 500 eingreifen. Ferner kann an den Leitungsenden 558, 559, 560 eine Schirmung vorgesehen werden.

Da es sich bei den vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft.

### BEZUGSZEICHENLISTE

- 100, 200, 300, 400, 500: Koppelvorrichtung
- 101, 201, 301, 401, 501: Grundplatte
- 102, 202, 302, 402: Verbindungseinrichtung
- 103, 104, 105, 106: Rasthaken
- 203, 204, 205, 206: Rasthaken
- 303, 304, 305, 306: Rasthaken
- 403, 404, 504, 505: Rasthaken
- 107,108, 109, 110, 111, 112: Öffnung
- 207, 208, 209, 210, 211, 212: Öffnung
- 307, 308, 309, 310, 311, 312: Öffnung
- 113, 213, 313, 413: erste Seite
- 114, 214, 314, 414: zweite Seite
- 215: Koppeleinrichtung
- 216, 217: Rasthaken
- 218: Aufnahmeraumbegrenzung
- 219: Aufnahmeraum
- 325, 326: Distanzelement
- 327, 328: Stärke
- 430: Befestigungselement
- 431, 432: Rasthaken
- 540, 541, 542, 543, 544, 545: Rasthaken
- 546: Aufnahmeraumbegrenzung
- 547: Abdeckeinrichtung
- 548: Befestigungselement
- 549: Öffnung
- 550: Baugruppe
- 551: Bauteilträger
- 552, 553: Leitungseinheit
- 554, 555: Leitung
- 556, 557: Positioniereinheit/mechanisches Verbindungselement
- 558, 559, 560: Leitungsende
- S1, S2, S3: Verfahrensschritte

## Patentansprüche

1. Koppelvorrichtung (100, 200, 300, 400, 500) zur Kopplung einer Anzahl von Leitungseinheiten (552, 553) mit einem Bauteilträger (551), wobei die Koppelvorrichtung (100, 200, 300, 400, 500) aufweist:
eine zumindest in einer Ebene flächig ausgebildete Grundplatte (101, 201, 301, 401, 501),
eine Verbindungseinrichtung (102, 202, 302, 402), welche auf einer ersten Seite (113, 213, 313, 413) der Grundplatte (101, 201, 301, 401, 501) angeordnet ist und ausgebildet ist, die Grundplatte (101, 201, 301, 401, 501) mechanisch mit dem Bauteilträger (551) zu koppeln, und
eine durch die Grundplatte (101, 201, 301, 401, 501) führende Öffnung (107, 108, 109, 110, 111, 112, 207, 208, 209, 210, 211, 212, 307, 308, 309, 310, 311, 312, 549) für jedes Leitungsende (558, 559, 560) einer Anzahl von Leitungsenden (558, 559, 560) der Leitungseinheiten (552, 553), wobei die mindestens eine Öffnung (107, 108, 109, 110, 111, 112, 207, 208, 209, 210, 211, 212, 307, 308, 309, 310, 311, 312, 549) an einer der jeweiligen Leitungseinheit (552, 553) entsprechenden Position auf der Grundplatte (101, 201, 301, 401, 501) angeordnet sind.

2. Koppelvorrichtung (100, 200, 300, 400, 500) gemäß dem vorhergehenden Anspruch, mit einer Koppeleinrichtung (215) für jede der Leitungseinheiten (552, 553), welche auf einer der ersten Seite (113, 213, 313, 413) gegenüberliegenden zweiten Seite (114, 214, 314, 414) der Grundplatte (101, 201, 301, 401, 501) angeordnet ist und ausgebildet ist, die jeweilige Leitungseinheit (552, 553) in einem entsprechenden Aufnahmeraum (219) aufzunehmen und mechanisch zu fixieren.

3. Koppelvorrichtung (100, 200, 300, 400, 500) gemäß einem der vorhergehenden Ansprüche, mit mindestens einem mechanischen Positionierelement, welches ausgebildet ist, ein Koppeln der Verbindungseinrichtung (102, 202, 302, 402) mit dem Bauteilträger (551) lediglich dann freizugeben, wenn die Koppelvorrichtung (100, 200, 300, 400, 500) auf dem Bauteilträger (551) in einer vorgegebenen Position angeordnet ist.

4. Koppelvorrichtung (100, 200, 300, 400, 500) gemäß einem der vorhergehenden Ansprüche, mit einer Aufnahmeraumbegrenzung (218, 546) für jeden der Aufnahmeräume, wobei insbesondere jede der Aufnahmeraumbegrenzungen (218, 546) eine eindeutige vorgegebene Geometrie aufweist.

5. Koppelvorrichtung (100, 200, 300, 400, 500) gemäß einem der vorhergehenden Ansprüche, wobei die Öffnungen (107, 108, 109, 110, 111, 112, 207, 208, 209, 210, 211, 212, 307, 308, 309, 310, 311, 312, 549) in der Grundplatte (101, 201, 301, 401, 501) von der zweiten Seite (114, 214, 314, 414) zur ersten Seite (113, 213, 313, 413) einen sich verjüngenden Querschnitt aufweisen.

6. Koppelvorrichtung (100, 200, 300, 400, 500) gemäß dem vorhergehenden Anspruch, wobei die Öffnungen (107, 108, 109, 110, 111, 112, 207, 208, 209, 210, 211, 212, 307, 308, 309, 310, 311, 312, 549) an ihrem an der ersten Seite (113, 213, 313, 413) der Grundplatte (101, 201, 301, 401, 501) liegenden Ende jeweils einen Anschlag aufweisen.

7. Koppelvorrichtung (100, 200, 300, 400, 500) gemäß einem der vorhergehenden Ansprüche, mit einer Anzahl von Distanzelementen (325, 326), welche auf der ersten Seite (113, 213, 313, 413) der Grundplatte (101, 201, 301, 401, 501) angeordnet sind und eine vorgegebene Stärke (327, 328) aufweisen.

8. Koppelvorrichtung (100, 200, 300, 400, 500) gemäß einem der vorhergehenden Ansprüche, mit einer Anzahl von Abdeckeinrichtungen (547), welche sich ausgehend von der Grundplatte (101, 201, 301, 401, 501) erstrecken.

9. Koppelvorrichtung (100, 200, 300, 400, 500) gemäß einem der vorhergehenden Ansprüche, mit einer Anzahl von Befestigungselementen (430, 548), welche ausgebildet sind, die Koppelvorrichtung (100, 200, 300, 400, 500) mit einer externen Aufnahme mechanisch zu koppeln.

10. Koppelvorrichtung (100, 200, 300, 400, 500) gemäß einem der vorhergehenden Ansprüche, mit einer Anzahl von durch die Grundplatte (101, 201, 301, 401, 501) führenden Schirmungsöffnungen für mindestens eine der Leitungseinheiten (552, 553), welche ausgebildet sind, Kontakte einer Schirmung der mindestens einen Leitungseinheit (552, 553) aufzunehmen.

11. Baugruppe (550) aufweisend:
eine Anzahl von Leitungseinheiten (552, 553) mit jeweils einer Anzahl von Leitungsenden (558, 559, 560),
einen flächig ausgebildeten Bauteilträger (551) mit einem Kontaktelement für jedes der Leitungsenden (558, 559, 560), und
eine Koppelvorrichtung (100, 200, 300, 400, 500) nach einem der vorherigen Ansprüche,
wobei die Koppelvorrichtung (100, 200, 300, 400, 500) zwischen den Leitungseinheiten (552, 553) und dem Bauteilträger (551) angeordnet ist und mechanisch zumindest mit dem Bauteilträger (551) gekoppelt ist, und
wobei jedes der Leitungsenden (558, 559, 560) durch eine Öffnung (107, 108, 109, 110, 111, 112, 207, 208, 209, 210, 211, 212, 307, 308, 309, 310, 311, 312, 549) der Koppelvorrichtung (100, 200, 300, 400, 500) zu dem jeweiligen Kontaktelement reicht und mit dem jeweiligen Kontaktelement elektrisch gekoppelt ist.

12. Baugruppe (550) gemäß dem vorhergehenden Anspruch, wobei die Koppelvorrichtung (100, 200, 300, 400, 500) ferner eine Koppeleinrichtung (215) aufweist, welche mechanisch mit den Leitungseinheiten (552, 553) gekoppelt ist.

13. Baugruppe (550) gemäß einem der vorhergehenden Baugruppen-bezogenen Ansprüche, wobei zumindest eine der Leitungseinheiten (552, 553) eine Positioniereinheit (556, 557) aufweist, welche ausgebildet ist, die Leitungsenden (558, 559, 560) der Leitungseinheit (552, 553) mechanisch in einer vorgegebenen Position zu fixieren, und/oder
wobei zumindest eine der Leitungseinheiten (552, 553) ein mechanisches Verbindungselement aufweist, welches um die Leitung der Leitungseinheit (552, 553) angeordnet ist und ausgebildet ist, mechanisch in eine Koppeleinrichtung (215) der Koppelvorrichtung (100, 200, 300, 400, 500) einzugreifen, und/oder
wobei mindestens eine der Leitungseinheiten (552, 553) eine Schirmung aufweist.

14. Verfahren zum Herstellen einer Baugruppe (550), aufweisend die folgenden Schritte:
Koppeln (S1) eines Bauteilträgers (551) mit einer Koppelvorrichtung (100, 200, 300, 400, 500) nach einem der vorhergehenden Ansprüche 1 bis 10,
Einführen (S2) von Leitungsenden (558, 559, 560) in entsprechende Öffnungen (107, 108, 109, 110, 111, 112, 207, 208, 209, 210, 211, 212, 307, 308, 309, 310, 311, 312, 549) der Koppelvorrichtung (100, 200, 300, 400, 500), und
elektrisch Koppeln (S3) der Leitungsenden (558, 559, 560) mit entsprechenden Kontaktelementen des Bauteilträgers (551).

15. Verfahren gemäß dem vorhergehenden Anspruch, wobei vor dem Einführen (S2) die Leitungsenden (558, 559, 560) in einer Positioniereinheit (556, 557) mechanisch fixiert werden, und/oder
wobei vor dem Einführen (S2) die Leitungsenden (558, 559, 560) abisoliert und/oder verzinnt werden, und/oder
wobei vor dem Einführen (S2) die Leitungsenden (558, 559, 560) mit einer Schirmung versehen werden, und/oder
wobei vor dem Einführen (S2) die Leitungsenden (558, 559, 560) jeweils mit einem mechanischen Verbindungselement versehen werden, welches um die Leitung der Leitungseinheit (552, 553) angeordnet ist und ausgebildet ist, mechanisch in eine Koppeleinrichtung (215) der Koppelvorrichtung (100, 200, 300, 400, 500) einzugreifen, und/oder
wobei das elektrische Koppeln (S3) ein Wellenlöten oder Schwalllöten aufweist.
